Europäisches Patentamt

**European Patent Office**

**Office européen des brevets**

(11) Numéro de publication: **0 002 997**
**A2**

(12) # DEMANDE DE BREVET EUROPEEN

(21) Numéro de dépôt: **78430020.4**

(22) Date de dépôt: **17.11.78**

(51) Int. Cl.²: **H 01 L 29/78, H 01 L 29/10, H 01 L 21/18**

(30) Priorité: **23.12.77 US 864074**

(43) Date de publication de la demande: **11.07.79**
**Bulletin 79/14**

(84) Etats contractants désignés: **DE FR GB**

(71) Demandeur: **International Business Machines Corporation, Armonk, N.Y. 10504 (US)**

(72) Inventeur: **Ning, Tak H., 1720 Maxwell Drive, Yorktown New York 10598 (US)**
Inventeur: **Osburn, Carlton M., 41 Morningside Drive, Croton-on-Hudson New York 10520 (US)**
Inventeur: **Yu, Hwa N., 2849 Hickory Street, Yorktown Heights New York 10598 (US)**

(74) Mandataire: **Klein, Daniel, COMPAGNIE IBM FRANCE Département de Propriété Industrielle, F-06610 La Gaude (FR)**

(54) Transistor à effet de champ à portes superposées et auto-alignées et procédé de fabrication.

(57) La présente invention concerne un transistor à effet de champ à portes superposées et son procédé de fabrication. Le transistor est essentiellement caractérisé en ce que la porte flottante (6) et la porte de commande (8) sont auto-alignées l'une avec l'autre et qu'en outre, elles sont auto-alignées avec les régions de source (12) et de drain (13). De préférence le matériau constitutif des portes est le silicium polycristallin. Le procédé de fabrication ne comprend que quatre étapes de masquage pour aboutir à la structure représentée. Ce transistor peut être utilisé dans les mémoires reprogrammables électriquement.

FIG 7

1

# TRANSISTOR A EFFET DE CHAMP A PORTES SUPERPOSEES ET AUTO-ALIGNEES ET PROCEDE DE FABRICATION

## Description

### Domaine Technique

La présente invention concerne les transistors à effet de champ (FET) ainsi que la préparation de circuits intégrés contenant des ensembles de FET. Elle concerne plus particulièrement, des FET qui comprennent une porte flottante et une porte de commande auto-alignées entre-elles et avec les régions de source et de drain ainsi que le procédé de fabrication de tels FET. Le procédé de la présente invention ne nécessite que quatre étapes de masquage (délimitation de configurations) pour réaliser un tel FET et donc un circuit intégré désiré comportant un ensemble de ces FET ainsi que les circuits associés d'adressage, de décodage et de détection.

### Etat de la technique

On s'intéresse depuis quelques années à des FET qui comportent une "porte flottante" et une porte de commande superposées. La porte flottante diffère de la porte de commande en ce qu'elle n'est pas connectée et qu'elle

0002997

2

est totalement isolée. De tels FET sont décrits, par exemple, dans les brevets des E.U.A Nos. 3 825 945, 3 825 946, 3 836 992, 3 868 187, 3 881 180, 3 893 151, 3 950 738, 3 084 822 et 3 985 591.

La porte de commande permet au dispositif de fonctionner comme un FET à porte isolée (IGFET) normal, et la porte flottante constitue un espace dans lequel les électrons ou les trous injectés peuvent être emmagasinés et permet de ce fait au dispositif de fonctionner comme un dispositif de mémoire reprogrammable électriquement. La porte flottante permet également de modifier la tension de seuil requise pour transférer une charge de la source au drain. La présence de la porte de commande au-dessus de la porte flottante permet de mieux commander l'injection de charges dans cette dernière.

Les procédés connus qui servent à fabriquer des FET comportant une porte flottante et une porte de commande superposées, notamment ceux décrits dans les brevets précités, nécessitent au moins une opération de masquage supplémentaire par comparaison aux procédés employés pour réaliser des FET qui ne comportent qu'une seule porte. Les étapes de masquage dans la réalisation des circuits intégrés, sont parmi celles qui présentent le caractère le plus critique. Elles exigent en effet une grande précision en ce qui concerne l'alignement et leur exécution nécessite les plus grands soins. Chaque étape de masquage supplémentaire est susceptible d'endommager la surface par suite des défauts que peut comporter le masque, et aggrave les problèmes de cadrage entre les différents masques, ce qui a pour effet de diminuer le rendement et, par conséquent, d'augmenter

3

considérablement les coûts de fabrication des dispositifs. Bien que d'autres facteurs, tels que le nombre de traitements thermiques effectués à température élevée, affectent également le rendement et les coûts, tous les procédés de fabrication de circuits intégrés (notamment ceux comportant des FET) visent à réduire à un minimum le nombre d'étapes de masquage requises.

L'un des objets de la présente invention sera donc de fournir un procédé de fabrication de circuits intégrés comportant des FET qui nécessitera un nombre minimum d'étapes de masquage.

La fabrication des FET dans lesquels la source et le drain sont auto-alignés par rapport à la porte, particulièrement lorsque cette dernière est en polysilicium, est bien connue. Dans la technique utilisée à cette fin, on délimite la porte (par exemple en silicium) avant de former les régions de source et de drain. Les bords de la porte et ceux de l'isolant de champ sont utilisés comme masque pour définir les limites des régions de source et de drain réalisées par implantation d'ions ou par diffusion. Un procédé de fabrication de régions de source et de drain auto-alignées, réalisées par implantation d'ions, est décrit dans l'article de R.H. Dennard et al, intitulé "Design of Ion-Implanted MOSFET's with Very Small Physical Dimensions" paru dans la publication "IEEE J. Solid-State Circuits", Vol. SC-9, pages 256 à 268, octobre 1974. D'autres techniques intéressantes sont décrites notamment dans les brevets des E.U.A. Nos. 3 849 216, 3 895 390, 3 897 282, 3 946 419, 3 967 981 et 3 972 756. Le brevet des E.U.A No. 3 996 657 décrit un agencement à portes superposées en polysilicium dans lequel des régions secondaires de

4

source et de drain sont auto-alignées avec une porte flottante avant de procéder à la formation d'une porte de commande et de régions primaires de source et de drain alignées avec cette dernière porte. Les brevets des E.U.A No. 3 897 282 et 3 984 822 décrivent des agencements à portes superposées en polysilicium dans lesquels seule la porte qui est la plus proche du substrat semi-conducteur est auto-alignée avec les régions de source et de drain.

Par ailleurs, l'article de A. Scheibe et al intitulé "Technology of a New n-Channel One-Transistor EAROM Cell Called SIMOS" paru dans la publication "IEEE Transactions on Electron Devices", vol. ED-24, No.5, fait allusion à un procédé dans lequel la porte de commande et la porte flottante sont auto-alignées dans le sens de la largeur mais non dans le sens de la longueur. La porte de commande est plus longue que la porte flottante et, de ce fait, les deux portes ne sont pas complètement auto-alignées.

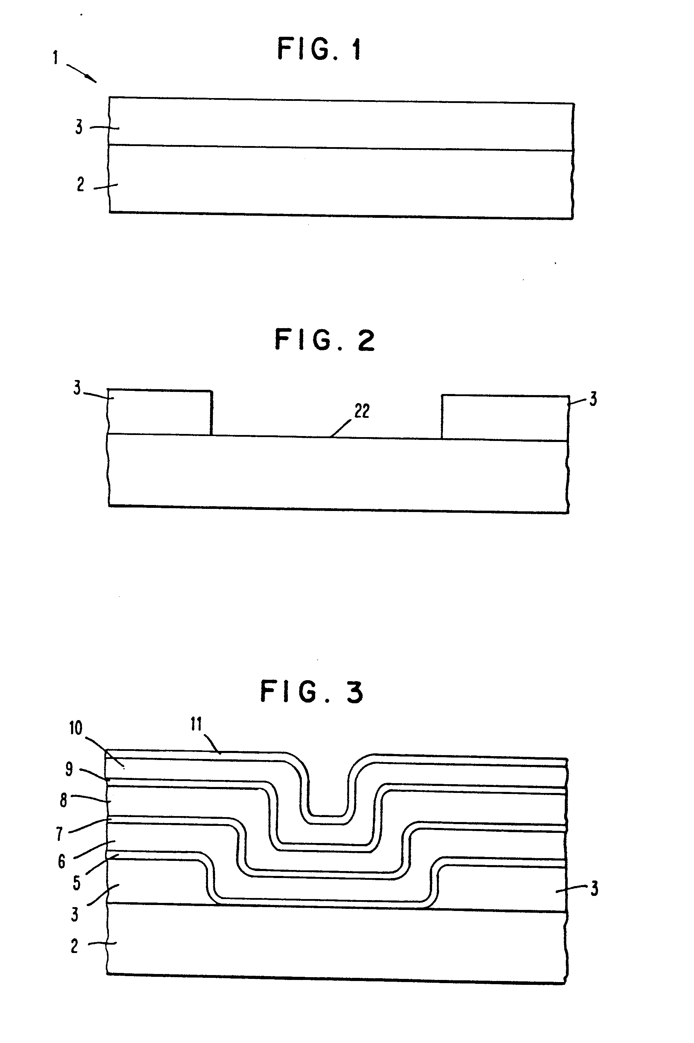

Le procédé décrit dans cet article nécessite une première étape de masquage dont le but est de définir "provisoirement" la porte flottante, après quoi l'on dépose un oxyde et du polysilicium. On procède ensuite à une seconde étape de masquage qui permet de définir la porte de commande et de supprimer les parties de la porte flottante qui pourraient dépasser les limites de la porte de commande. On forme ensuite les régions de source et de drain. La source et le drain sont auto-alignés sur toute la longueur de la porte de commande délimitée par les bords de l'isolant de champ. Comme le montre la figure 2 dudit article, la porte de commande est plus longue que la porte flottante. Le procédé

5

décrit dans cet article nécessite non seulement des étapes supplémentaires de masquage, mais aussi une étape supplémentaire permettant, une fois la porte flottante provisoirement définie, d'assurer l'isolation des bords de celle-ci qui auraient été exposés lors du processus de délimitation.

## Exposé de la présente invention

Selon la présente invention, la porte flottante et la porte de commande sont auto-alignées l'une avec l'autre dans le sens de la longueur aussi bien que dans le sens de la largeur, et sont en outre auto-alignées avec les régions de source et de drain. Cet auto-alignement est obtenu, selon la présente invention, au moyen d'un nombre minimum d'étapes de masquage. L'invention permet en outre, puisque les dimensions latérales (longueur et largeur) des portes sont identiques, de réduire au minimum la surface occupée par celles-ci, ce qui permet de réduire la capacité de recouvrement.

La présente invention concerne un transistor à effet de champ (FET) à portes superposées du genre comportant une porte flottante, une porte de commande disposée au-dessus de la porte flottante et séparée de celle-ci par un isolant, et des régions source et drain, caractérisé en ce que les portes sont d'une part auto-alignées l'une par rapport à l'autre dans le sens de la longueur et dans le sens de la largeur, et d'autre part auto-alignées avec les régions de source et de drain.

La présente invention concerne également un procédé permettant de fabriquer un tel FET à portes superposées et par là un circuit intégré comportant un ensemble de ces FET. Le procédé est caractérisé en ce qu'il comprend

6

les étapes suivantes:

(a) élaboration d'un substrat semi-conducteur d'un premier type de conductivité,

(b) élaboration et délimitation de régions isolantes selon une configuration désirée, de manière à obtenir des régions de champ isolantes et exposer une région désirée du substrat,

(c) formation d'une première couche isolante pour une porte flottante qui sera définie ultérieurement,

(d) formation d'une première couche conductrice en silicium polycristallin dopé ou en un métal réfractaire ou encore en un siliciure de métal réfractaire, au-dessus de la première couche isolante,

(e) formation d'une seconde couche isolante au-dessus de la première couche conductrice,

(f) formation d'une seconde couche conductrice en silicium polycristallin dopé en siliciure de métal réfractaire au-dessus de la seconde couche isolante,

(g) délimitation de la première couche conductrice et de la seconde couche conductrice en utilisant le même masque de façon à obtenir une porte composite comprenant une porte flottante et une porte de commande respectivement, auto-alignées l'une avec l'autre dans toutes les dimensions latérales (longueur et largeur), et des régions exposées restantes qui seront ultérieurement dopées pour constituer les régions de source et de drain,

(h) introduction d'impuretés actives d'un second type de conductivité par diffusion thermique

7

ou implantation d'ions dans ces régions exposées restantes du substrat semi-conducteur pour obtenir des régions de source et de drain qui soient auto-alignées avec les portes flottante et de commande (dans le sens de la longueur, c'est-à-dire dans une direction othogonale au canal),

(i)     formation d'une troisième couche isolante,

(j)     délimitation de la configuration des trous de contact avec la porte de commande et avec les régions de source et de drain,

(k)     délimitation d'une configuration désirée d'interconnexions électriques de forte conductivité permettant d'établir des connexions électriques avec la porte de commande du FET, et les régions de source et de drain.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

Les figures 1 à 6 sont des vues de côté d'un FET pendant les différentes étapes de sa réalisation.

La figure 7 est une vue en coupe longitudinale de la structure d'un dispositif conforme à celui représenté sur la figure 6 dans le sens des flèches 7-7.

8

## Généralités

Dans un but de commodité, les étapes du procédé de fabrication seront décrites ci-après dans le cas de l'emploi d'un substrat en silicium de type p muni de régions source et drain de type n. Cela correspond à la technologie dite des FET à canal n. Cependant un substrat de type n muni de régions source et drain de type p peut également être utilisé, conformément à la présente invention. Il suffit à l'homme de l'art d'apporter dans la présente description de simples modifications bien connues de lui.

En outre il est sous-entendu que la présente invention s'applique également à d'autres matériaux que le silicium. Par ailleurs, les termes "conducteurs d'interconnexion électriques de forte conductivité" se rapportent dans le présent contexte à des conducteurs métalliques, par exemple en aluminium, mais aussi à des matériaux non métalliques (par exemple du polysilicium fortement dopé ou des siliciures intermétalliques) qui peuvent néanmoins présenter des conductivités comparables à celles que possèdent généralement les métaux conducteurs. Les termes "polysilicium" et "silicium polycristallin" utilisés ici sont interchangeables, au même titre que dans l'art antérieur. En ce qui concerne les allusions faites ci-après à des impuretés d'un "premier type" et d'un "second type", il est sous-entendu que ces expressions se rapportent respectivement à des types de conductivité opposés: si le "premier type" est du type p, le "second type" est du type n, et vice versa.

Dans un but de simplicité, la technique photolithographique est mentionnée ci-après à propos de la description

9

des étapes de fabrication, mais d'autres techniques lithographiques, telles que celles qui font appel à l'emploi d'un faisceau électronique, peuvent éventuellement être utilisées. De même, bien qu'il soit fait allusion ci-après à un décapage chimique du type humide, d'autres techniques de décapage, telles que le décapage par ions réactifs, peuvent éventuellement être employées.

Enfin, bien que, dans le procédé de fabrication décrit ci-après, le matériau préféré utilisé pour la réalisation de la porte flottante et de la porte de commande soit du silicium polycristallin, d'autres matériaux peuvent être utilisés à cette même fin. En particulier, la porte flottante peut être réalisée à partir d'un métal et de préférence un métal réfractaire ou d'un siliciure de celui-ci, et la porte de commande à partir d'un siliciure d'un métal réfractaire. Dans le présent contexte, un métal réfractaire est un métal qui peut résister aux températures élevées qui sont utilisées en cours de fabrication sans dégradation inacceptable. A titre d'exemple, on peut utiliser comme métal réfractaire: le tungstène, le tantale, le hafnium et le rhodium, et, comme siliciure convenable, du siliciure de tungstène, de tantale, de hafnium ou de rhodium.

Description d'un mode de réalisation

On a représenté sur la figure 1 la structure initiale référencée en 1. Un substrat 2 en silicium de type p présentant une orientation cristalline désirée quelconque (par exemple, 100) est élaboré en découpant et en polissant un barreau de silicium de type p que l'on fait croître en présence d'un dopant de type p tel que

10

du bore, en utilisant des techniques classiques de croissance. L'aluminium, le gallium et l'indium peuvent notamment être utilisés comme dopants de type p.

L'isolant de champ en oxyde peut être formé au moyen de différentes techniques connues, notamment par oxydation thermique du substrat semi-conducteur ou par dépôt sous vide ou en phase vapeur. D'autre part, l'oxyde de champ peut être formé au-dessus de la surface semi-conductrice ou être partiellement ou complètement encastré dans le substrat semi-conducteur. Une technique dans laquelle l'isolant en oxyde est complètement encastré est décrite, par exemple, dans le brevet des E.U.A. No. 3 899 363.

Dans la présente description, on utilisera à titre d'exemple un isolant de champ en oxyde non encastré. Les isolants de champ ont une épaisseur généralement comprise entre 4000 et 10 000 angströms environ. Les régions de champ 3 en oxyde et la région active 22 du dispositif (voir figure 2) sont délimitées au moyen d'une première étape de masquage lithographique. Le masque utilisé se compose d'un matériau transparent qui comporte des parties opaques selon une configuration prédéterminée.

On forme ensuite sur le substrat en silicium 2, une mince couche de dioxyde de silicium 5 (voir figure 3) constituant l'isolant de la porte flottante. Cet isolant, dont l'épaisseur est généralement comprise entre 200 et 1000 $\overset{\circ}{A}$ environ, peut être formé soit par dépôt soit par oxydation thermique de la surface en silicium à 1000°C environ en présence d'oxygène sec.

On procède ensuite à la formation d'une couche de

11

silicium polycristallin 6 (voir figure 3), qui peut avoir une épaisseur comprise entre 1500 et 5000 Å environ et qui être formée par dépôt chimique en phase vapeur. Cette couche est ensuite dopée au moyen d'un dopant de type n tel que de l'arsenic, du phosphore ou de l'antimoine en utilisant une technique classique quelconque. De préférence, on utilise la technique qui consiste à déposer une couche de $POCl_3$ à environ 870°C et à la porter ensuite à une température d'environ 1000°C pour faire pénétrer le phosphore dans le poly-silicium, qui devient alors du type n. On retire ensuite la partie restante de la couche de $POCl_3$ en décapant la tranche avec de l'acide fluorhydrique tamponné. Cette couche de silicium polycristallin 6 sera ultérieurement délimitée de manière à former la porte flottante. On préfère, dans ce présent mode de réalisation, le poly-silicium pour constituer la porte en raison de la facilité avec laquelle ce matériau s'oxyde. Cependant, elle pourrait être constituée par un métal réfractaire ou un siliciure de métal réfractaire.

On forme ensuite, sur la couche 6, une couche relativement mince de dioxyde de silicium 7 (voir figure 3) constituant l'isolant de la porte de commande. Cette couche 7, dont l'épaisseur est en principe comprise entre 200 et 2000 angströms environ, peut être formée soit par dépôt, soit par oxydation thermique de la surface 6 à 1000°C environ en présence d'oxygène sec.

On forme alors une seconde couche de silicium polycristallin (voir figure 3), qui sera ultérieurement délimitée pour former la porte de commande. Cette couche a une épaisseur de 1500 à 5000 angströms environ et de préférence 3500 angströms et elle peut être formée

12

par dépôt chimique en phase vapeur. Cette couche est ensuite dopée au moyen d'un dopant de type n, tel que de l'arsenic, du phosphore ou de l'antimoine au moyen d'une technique classique quelconque. De préférence, le polysilicium est dopé avec du phosphore et la technique utilisée de préférence consiste à déposer une couche de $POCl_3$ à 870°C environ et à la porter ensuite à une température d'environ 1000°C de manière à faire pénétrer le phosphore dans le polysilicium, qui devient alors de type n. Cela fait, on retire la partie restante de la couche de $POCl_3$ en trempant la tranche dans de l'acide fluorhydrique tamponné. On forme ensuite, par dépôt ou croissance, sur la couche de polysilicium, une mince couche de dioxyde de silicium 9 (voir figure 3) d'une épaisseur de 50 à 200 angströms environ. Cette couche est destinée à empêcher une couche 10, ultérieurement déposée, de réagir avec le polysilicium, le retrait de cette couche 10 après réaction étant généralement très difficile. Ici également on aurait pu utiliser, pour constituer la porte de commande, un siliciure de métal réfractaire.

On procède ensuite au dépôt de cette couche 10 (voir figure 3). Cette couche qui se compose d'un matériau tel que du nitrure de silicium, du nitrure d'aluminium, du nitrure de bore, de l'oxyde d'aluminium ou du carbure de silicium, sert de masque de décapage pour délimiter la configuration de porte. La couche 10 est de préférence en nitrure de silicium et a une épaisseur d'environ 500 à 1000 Å. Elle peut être déposée au moyen d'une technique classique de dépôt chimique en phase vapeur. Une couche supplémentaire de dioxyde de silicium 11 est enfin déposée. Cette couche 11 a une épaisseur d'environ 500 à 1000 Å et peut être formée par dépôt chimique en phase vapeur. Cette dernière couche fait fonction de masque de décapage pour délimiter la couche 11. L'ensemble ainsi obtenu est représenté sur la figure 3. Le dispositif est ensuite recuit à 1000°C environ pendant 5 minutes environ.

On forme une couche de masquage d'un matériau photorésistant (non représentée) du type employé dans les techniques classiques de masquage lithographique, sur la surface de la couche d'oxyde supérieure 11. N'importe lequel des matériaux photo-résistants polymérisables utilisés dans l'art antérieur peut être employé. Le matériau photo-résistant est appliqué, par exemple, par pulvérisation ou par centrifugation.

On fait sécher la couche de matériau photo-résistant (non représentée), puis on l'expose de façon sélective à une radiation ultraviolette au travers d'un masque photolithographique. Ce masque est réalisé en un matériau transparent et comporte des parties opaques selon une configuration prédéterminée. La tranche est exposée à travers ce masque à une lumière ultraviolette, polymérisant ainsi les parties du matériau photorésistant qui se trouvent au-dessous des parties transparentes du masque. Après retrait de ce dernier, on rince la tranche dans une solution de développement appropriée, qui retire les parties du matériau photo-résistant qui se trouvaient au-dessous des parties opaques du masque et n'avaient donc pas été exposées à la lumière ultraviolette. L'ensemble peut alors être cuit de manière à provoquer une nouvelle polymérisation et un durcissement du matériau photo-résistant restant qui est conforme à la configuration désirée, c'est-à-dire qui recouvre les régions dans lesquelles les portes en polysilicium

14

seront ultérieurement formées.

L'ensemble est ensuite traité de manière à retirer les parties d'oxyde de silicium 11 qui ne sont pas protégées par le matériau photorésistant. La structure est plongée dans une solution d'acide fluorhydrique tamponné. La solution de décapage dissout le dioxyde de silicium, mais n'attaque ni le matériau photorésistant, ni la couche 10.

Les parties restantes du matériau photorésistant sont ensuite retirées en les dissolvant au moyen d'un solvant approprié. Les régions restantes de la couche 11 en dioxyde de silicium répondent à une configuration prédéterminée et servent à présent de masque pour décaper des configurations prédéterminées dans la couche 10. Cette dernière fait alors fonction de masque aux fins du décapage d'une configuration désirée, successivement dans la couche d'oxyde mince 9, dans la couche de polysilicium 8, dans la couche d'oxyde mince 7, dans la couche de polysilicium 6, et dans la couche d'oxyde mince 5.

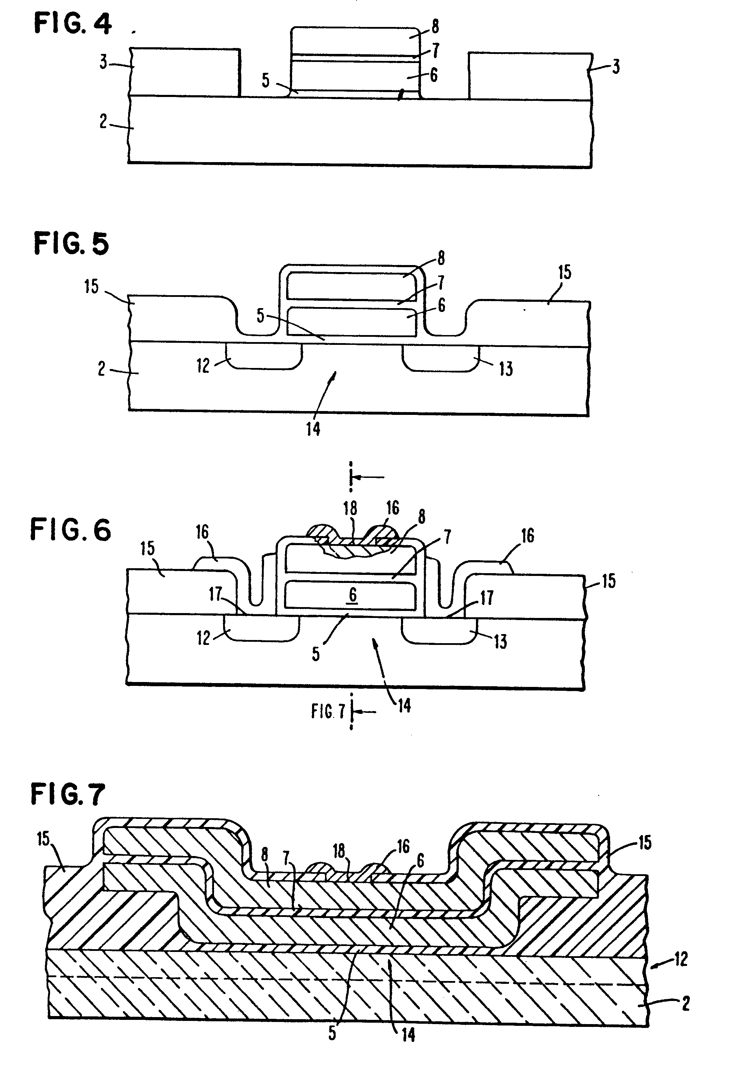

Si la couche 10 est en nitrure de silicium, son décapage peut s'effectuer dans une solution d'acide phosphorique à 180°C. Le décapage des couches d'oxyde mince 5, 7, 9 et 11, s'effectue dans une solution d'acide fluorhydrique tamponné. Enfin le décapage des couches de polysilicium (6, 8) s'effectue au moyen d'un décapant classique tel que de l'éthylène-diamine pyrocatéchine 1-2 à 100°C. On retire ensuite les parties restantes de la couche 10. Si l'on utilise du nitrure de silicium, ce résultat peut être obtenu en effectuant un décapage dans une solution d'acide phosphorique à 180°C environ. Cela constitue la dernière partie de la seconde étape

15

de masquage lithographique qui permet de délimiter la porte de commande et la porte flottante. Etant donné que cette délimitation est obtenue au moyen d'un même masque lithographique, les deux portes sont auto-alignées l'une par rapport à l'autre dans toutes les dimensions latérales (voir figures 4 et 7).

Les régions de source et de drain de type n sont ensuite formées au moyen de techniques bien connues d'implantation d'ions ou de diffusion. Pour les besoins de la présente description, on a choisi d'employer une technique de diffusion thermique. Par exemple, les régions de source et de drain 12 et 13 de type n (voir figure 5) pourraient être formées en déposant une couche de $POCl_3$ avec une concentration en phase gazeuse d'environ 5500 ppm à 870°C environ, puis en portant celle-ci à une température d'environ 1000°C de manière à faire pénétrer le phosphore dans le substrat en silicium 2. Pendant la diffusion thermique, la porte composite formée des portes en polysilicium 6 et 8 et les couches de dioxyde de silicium 7 et 9, font fonction de masque et empêchent les impuretés dopantes de type n de pénétrer dans la région du canal 14 du FET au-dessous des portes en polysilicium 6 et 8. De même, la région épaisse d'oxyde de champ 3 fait fonction de masque et empêche les impuretés de type n de pénétrer dans les régions d'isolement de champ.

Les limites entre les régions de source et de drain de type n et le canal du FET sont définies par les portes en polysilicium 6 et 8 (voir figure 5). Ces deux portes étant auto-alignées avec la source et le drain, les capacités parasites de recouvrement porte-source et porte-drain sont moins importantes que dans le cas des

16

autres techniques de fabrication de FET, ce qui est avantageux.

Une couche d'isolement diélectrique 15 est ensuite formée au-dessus de la porte en polysilicium 8 et au-dessus des régions de source et de drain 12 et 13 qui ne sont pas recouvertes par les portes en poly-silicium. La formation de la couche 15 (qui comprendrait le cas échéant la couche vitreuse de POCl$_3$) permet également d'augmenter l'épaisseur de la couche d'oxyde de champ 3. La couche 15 isole électriquement le conducteur relié à la porte de commande qui sera ultérieurement formé et les régions de source et de drain. Cette couche 15 permet également de diminuer les couplages capacitifs. Il est donc souhaitable que la couche 15 soit aussi épaisse que possible, sans pour autant provoquer de dégradation des conducteurs ni créer des discontinuités dans ces derniers.

Cette couche 15 au-dessus de la porte de commande 8 et des régions source et drain, d'une épaisseur de 1500 à 5000 angströms est obtenue en faisant croître du dioxyde de silicium par oxydation thermique à une température comprise entre 800 et 1100°C en présence d'oxygène. Pendant cette oxydation, une partie, d'une épaisseur comprise entre 600 et 2000 angströms environ, de la porte 8 en polysilicium de 3500 angströms est convertie en dioxyde de silicium; en outre une partie, d'une épaisseur comprise entre 600 et 2000 angströms environ, du substrat en silicium au-dessus des régions de source et de drain de type n est également convertie en dioxyde de silicium. Les régions de source et de drain 12 et 13 sont attirées à l'intérieur du substrat et latéralement autour de l'oxyde que l'on fait croître. Etant donné

0002997

17

que ce dernier tend à chasser les dopants de type n, la concentration en dopant de type n ne diminue pas de façon importante pendant cette oxydation. Les côtés latéraux des portes 6 et 8 sont exposés à l'oxydation, ce qui offre l'avantage de fournir un isolant protecteur. Pendant l'oxydation, l'épaisseur de l'oxyde de champ 3 augmente de 500 à 1500 angströms environ, ce qui est également avantageux.

Le dispositif peut alors être recuit, si cette opération est jugée souhaitable, en l'exposant à une température de 500°C environ pendant 30 minutes environ.

Lors de la fabrication de circuits intégrés comportant des FET, il est nécessaire de connecter les conducteurs à la porte de commande 8 et aux régions de source et de drain du type n. Ce résultat est obtenu en appliquant à l'ensemble une couche de matériau photorésistant. Ce matériau est exposé à une radiation ultraviolette en utilisant une configuration de masque lithographique prédéterminée, les régions qui ne sont pas exposées étant dissoutes. Cela constitue la troisième étape de masquage lithographique. L'ensemble est ensuite traité de manière à retirer les parties du dioxyde de silicium qui n'étaient pas protégées par le matériau photorésistant. Dans ce but, la tranche est plongée dans une solution d'acide fluorhydrique tamponné de manière à obtenir les trous de contact ou d'accès 17 et 18 (voir figure 6) dans la couche isolante 15. Ces trous permettront d'établir des connexions électriques avec la porte de commande en polysilicium 8 et avec les régions de source et de drain 12 et 13. Le matériau photorésistant qui subsiste au-dessus de la couche de dioxyde de silicium décapée est ensuite retiré par dissolution

18

dans un solvant approprié. A ce stade, la porte de commande 8 et les régions de source et de drain dans les trous de contact sont exposées aux fins de l'établissement de contacts.

Un matériau d'interconnexion 16 fortement conducteur, de préférence un métal, est ensuite déposé (voir figure 6). Un matériau fortement conducteur qui est communément utilisé aux fins de telles interconnexions est l'aluminium, qui peut contenir des quantités relativement faibles d'impuretés introduites pour diminuer l'effet d'électro-migration ou pour empêcher ou réduire les réactions chimiques entre l'aluminium et le matériau semi-conducteur avec lequel on désire établir un contact. Le matériau fortement conducteur, par exemple de l'aluminium, peut être déposé par pulvérisation ou, de préférence, par évaporation.

On notera qu'une couche servant de barrière (non représentée) peut être disposée entre l'aluminium et le matériau semi-conducteur en silicium ou en polysilicium de façon à prévenir ou à réduire les réactions chimiques entre l'aluminium et le matériau semi-conducteur. Cette couche peut être composée d'un matériau tel que le titane ou le chrome, ou d'un siliciure intermétallique tel que le siliciure de platine ou de palladium.

Une couche d'un matériau photorésistant est ensuite appliquée sur l'ensemble. Ce matériau est exposé à une lumière ultra-violette en utilisant une configuration de masquage prédéterminée, et les régions non exposées du matériau photorésistant sont dissoutes. Cela constitue la quatrième étape de masquage lithographique. L'ensemble est ensuite traité de manière à retirer les

19

parties du métal qui n'étaient pas protégées par le matériau photorésistant, comme le montre la figure 6. De façon classique, d'autres couches (non représentées), par exemple en dioxyde de silicium pulvérisé, peuvent être déposées sur la couche 16 afin de passiver le circuit intégré. D'autres étapes de masquage peuvent éventuellement être prévues, de façon classique, pour obtenir des trous d'accès dans la couche de passivation afin d'établir un contact avec la couche d'interconnexion métallique ou avec le substrat semi-conducteur. Une connexion électrique peut également être établie avec la surface arrière du substrat semi-conducteur. Par exemple, l'oxyde recouvrant la surface arrière pourrait être décapé, ce décapage étant suivi du dépôt d'un métal tel que l'aluminium. Le dispositif peut ensuite être recuit, si cette opération est jugée souhaitable, en l'exposant, par exemple, à une température de 400°C pendant 20 minutes environ dans une atmosphère composée de 10% de $H_2$ et de 90% de $N_2$.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

1

REVENDICATIONS

1. Transistor à effet de champ (FET) à portes superposées du genre comportant une porte flottante, une porte de commande disposée au-dessus de la porte flottante et séparée de celle-ci par un isolant, et des régions source et drain, caractérisé en ce que les portes sont d'une part auto-alignées l'une par rapport à l'autre dans le sens de la longueur et dans le sens de la largeur, et d'autre part auto-alignées avec les régions de source et de drain.

2. Transistor à effet de champ du genre comprenant:

(a) un substrat semi-conducteur d'un premier type de conductivité muni de régions source et drain d'un type de conductivité opposé, définissant une région de canal,

(b) un premier isolant disposé au-dessus de la région de canal,

(c) une porte flottante disposée au-dessus de l'isolant,

2

(d)    un second isolant disposé au-dessus de la porte flottante,

(e)    une porte de commande disposée au-dessus du second isolant, caractérisé en ce que la porte flottante et la porte de commande sont auto-alignées l'une par rapport à l'autre (dans le sens de la longueur et dans le sens de la largeur), et que la porte composite ainsi définie est auto-alignée avec les régions de source et de drain et dont les limites déterminent également celles de la région du canal du FET dans le sens de la longueur, ladite porte de commande étant auto-alignée par rapport à la porte flottante.

3.    Transistor à effet de champ selon la revendication 1 ou 2, caractérisé en ce que la porte flottante est en silicium polycristallin, un métal réfractaire ou un siliciure de métal réfractataire et en ce que la porte de commande est en silicium polycristallin et en siliciure d'un métal réfractaire.

4.    Transistor à effet de champ selon la revendication 3, caractérisé en ce que la porte flottante est en silicium polycristallin dopé et en ce que la porte de commande est en silicium polycristallin dopé.

5.    Transistor à effet de champ selon la revendication 3, caractérisé en ce que ledit métal réfractaire est choisi dans le groupe comprenant: le tungstène, le tantale, l'hafnium et le rhodium.

3

6.  Transistor à effet de champ selon l'une des revendications ci-dessus, caractérisé en ce qu'il
comprend également une couche isolante disposée au
moins au-dessus des régions de source et de drain
du FET, un conducteur d'interconnexion assurant
la liaison électrique avec la porte de commande et
des conducteurs d'interconnexion permettant d'établir
des connexions électriques avec lesdites régions
de drain et de source par l'intermédiaire des
trous d'accès.

7.  Transistor à effet de champ selon la revendication
6, caractérisé en ce qu'il comprend également une
connexion électrique avec la surface arrière du
substrat semi-conducteur.

8.  Transistor à effet de champ selon la revendication
6 ou 7, caractérisé en ce que le substrat semi-
conducteur est en silicium de type p, que lesdits
isolants de porte sont en dioxyde de silicium et
que le conducteur d'interconnexion est un métal.

9.  Procédé de fabrication d'un transistor à effet de
champ à portes superposées, caractérisé en ce qu'il
comprend les étapes suivantes:

    (a)  élaboration d'un substrat semi-conducteur
         d'un premier type de conductivité,
    (b)  élaboration et délimitation de régions isolantes
         selon une configuration désirée, de manière à
         obtenir des régions de champ isolantes et exposer une région désirée du substrat,

# 0002997

4

(c)    formation d'une première couche isolante pour une porte flottante qui sera définie ultérieurement,

(d)    formation d'une première couche conductrice en silicium polycristallin dopé ou en un métal réfractaire ou encore en un siliciure de métal réfractaire, au-dessus de la première couche isolante,

(e)    formation d'une seconde couche isolante au-dessus de la première couche conductrice,

(f)    formation d'une seconde couche conductrice en silicium polycristallin dopé en siliciure de métal réfractaire au-dessus de la seconde couche isolante,

(g)    délimitation de la première couche conductrice et de la seconde couche conductrice en utilisant le même masque de façon à obtenir une porte composite comprenant une porte flottante et une porte de commande respectivement, auto-alignées l'une avec l'autre dans toutes les dimensions latérales (longueur et largeur), et des régions exposées restantes qui seront ultérieurement dopées pour constituer les régions de source et de drain,

(h)    introduction d'impuretés actives d'un second type de conductivité par diffusion thermique ou implantation d'ions dans ces régions exposées restantes du substrat semi-conducteur pour obtenir des régions de source et de drain qui soient auto-alignées avec les portes flottante et de commande (dans le sens de la longueur, c'est-à-dire dans une direction othogonale au canal),

0002997

5

(i)  formation d'une troisième couche isolante,

(j)  délimitation de la configuration des trous de contact avec la porte de commande et avec les régions de source et de drain,

(k)  délimitation d'une configuration désirée d'interconnexions électriques de forte conductivité permettant d'établir des connexions électriques avec la porte de commande du FET, et les régions de source et de drain.

10.  Procédé de fabrication selon la revendication 9 caractérisé en ce que la porte flottante est en silicium polycristallin, un métal réfractaire ou un siliciure de métal réfractaire et en ce que la porte de commande est en silicium polycristallin et en siliciure d'un métal réfractaire.

11.  Procédé de fabrication selon la revendication 10 caractérisé en ce que la porte flottante est en silicium polycristallin dopé et en ce que la porte de commande est en silicium polycristallin dopé et en ce que le substrat semi-conducteur est de type p, les régions de champ isolantes sont en dioxyde de silicium et les interconnexions électriques sont en métal.

0002997

1/2

FIG. 1

3

2

1

FIG. 2

3                                    22                    3

FIG. 3

10   11
9
8
7
6
5
3

2

3

FIG. 4

FIG. 5

FIG. 6

FIG. 7